# EUROPÄISCHE PATENTANMELDUNG

(11) **EP 3 644 083 A1**
(43) Veröffentlichungstag der Anmeldung: **29.04.2020**
(21) Anmeldenummer: 18203748.1
(22) Anmeldetag: 31.10.2018
(51) Int. Cl.: G01R 33/28, G01R 33/385, G01R 33/421

(54) **LOKALSPULENEINHEIT ZUR REDUZIERUNG VON PHOSPHENEN**

(30) Priorität: 24.10.2018 EP 18202376
(71) Anmelder: Siemens Healthcare GmbH, 91052 Erlangen (DE)
(72) Erfinder: Kimmlingen, Ralph, 90513 Zirndorf (DE)

(57) **Zusammenfassung**

Die Erfindung betrifft eine Lokalspuleneinheit zur Positionierung in einem von einer Gradientenspuleneinheit umgebenen Patientenaufnahmebereich umfassend eine Leiterstruktur umgebend einen Lokalbereich,
wobei die Leiterstruktur dazu ausgebildet ist, im Lokalbereich ein lokales Magnetfeld zu erzeugen.

## Beschreibung

Die Erfindung betrifft eine Lokalspuleneinheit zur Positionierung in einem von einer Gradientenspuleneinheit umgebenen Patientenaufnahmebereich zur Erzeugung eines lokalen Magnetfeldes, ein entsprechendes Spulensystem, ein Magnetresonanzgerät und ein Verfahren zu einer Reduzierung eines von einer Gradientenspuleneinheit erzeugten globalen Magnetfeldgradienten in einem Lokalbereich.
In einem Magnetresonanzgerät wird üblicherweise der zu untersuchende Körper eines Untersuchungsobjektes, insbesondere eines Patienten, in einem Patientenaufnahmebereich mit Hilfe eines Hauptmagneten einem relativ hohen Hauptmagnetfeld, beispielsweise von 1,5 oder 3 Tesla, ausgesetzt. Zusätzlich werden mit Hilfe einer Gradientenspuleneinheit Gradientenpulse ausgespielt. Über eine Hochfrequenzantenneneinheit werden dann mittels geeigneter Antenneneinrichtungen hochfrequente Hochfrequenz-Pulse (HF-Pulse), insbesondere Anregungspulse, ausgesendet, was dazu führt, dass die Kernspins bestimmter, durch diese HF-Pulse resonant angeregter Atome um einen definierten Flipwinkel gegenüber den Magnetfeldlinien des Hauptmagnetfelds verkippt werden. Bei der Relaxation der Kernspins werden Hochfrequenz-Signale, so genannte Magnetresonanz-Signale, abgestrahlt, die mittels geeigneter Hochfrequenzantennen empfangen und dann weiterverarbeitet werden. Aus den so akquirierten Rohdaten können schließlich die gewünschten Bilddaten rekonstruiert werden.
Zum Erzeugen von Gradientenpulsen werden in die Gradientenleiterstrukturen der Gradientenspuleneinheit Ströme geleitet, deren Amplituden bis zu 1 kA erreichen und die häufigen und raschen Wechseln der Stromrichtung mit Anstiegs- und Abfallraten von mehreren 100 T/m/s unterliegen. Eine Gradientenspuleneinheit umfasst typischerweise drei Gradientenleiterstrukturen, wobei jede Gradientenleiterstruktur zur Erzeugung eines Magnetfeldgradienten in eine Raumrichtung ausgelegt ist. Ein Magnetfeldgradient ist typischerweise ein in eine räumliche Richtung linear ansteigendes Magnetfeld. Ein Magnetfeldgradient wird typischerweise temporär durch elektrische Ströme in einer Leiterstruktur erzeugt. Die elektrischen Ströme werden typischerweise gemäß Vorgabe einer MR-Steuerungssequenz durch eine Gradientensteuereinheit in der Gradientenspuleneinheit erzeugt, insbesondere bei Ansteuerung der Gradientenspuleneinheit und/oder des Magnetresonanzgerätes. Ein Magnetfeldgradient wird typischerweise als homogen bezeichnet, wenn der Magnetfeldgradient in eine Raumrichtung linear ansteigt. Ein Magnetfeldgradient wird typischerweise als homogen bezeichnet, wenn der Gradient des dadurch erzeugten Magnetfeldes, insbesondere dessen räumliche Ableitung, konstant, insbesondere räumlich konstant, ist.

Gradientenspuleneinheiten, welche derzeit in klinischen Systemen Anwendung finden, sind typischerweise derart ausgelegt, dass diese Magnetfeldgradienten mit einer maximalen Amplitude von 40-80mT/m und Anstiegs- und Abfallraten von 150-200T/m/s erzeugen können. Aus Stimulationsstudien mit höheren Anstiegs- und Abfallraten von >200mT/m und einer maximalen Amplitude von 300mT/m ist bekannt, dass bei der Erzeugung eines Magnetfeldgradienten in nur eine Raumrichtung visuelle Stimulationsphänomene, insbesondere Phosphene auftreten können. Diese Effekte basieren nach heutigem Wissensstand auf einer elektrischen Stimulation der Retina und treten nur bei Schaltungen von Magnetfeldgradienten im Frequenzbereich <100Hz mit einer maximalen Amplitude >100mT/m auf.

Die durch eine MR-Steuerungssequenz vorgegebenen Gradientenpulse erzeugen typischerweise einen Magnetfeldgradienten innerhalb des Patientenaufnahmebereiches, insbesondere innerhalb des Untersuchungsbereiches. Ein derartiger Magnetfeldgradient wird im Nachfolgenden als globaler Magnetfeldgradient bezeichnet. Insbesondere innerhalb des Untersuchungsbereiches ist ein globaler Magnetfeldgradient besonders homogen.

Für das Untersuchen von Körperregionen unterhalb des Kopfes, beispielsweise Lunge, Herz oder Leber, treten aufgrund von Streufeldern Stimulationen bei Magnetfeldgradienten mit geringeren maximalen Amplituden auf.

Da Gradientenspuleneinheiten mit einer höheren maximalen Amplitude und/oder einer höheren Anstiegs- und Abfallrate eine schnellere Akquisition von Rohdaten ermöglichen und insbesondere in der Diffusionsbildgebung wichtig sind, ist es wünschenswert, lokale Stimulationen außerhalb des Untersuchungsbereiches zu reduzieren und/oder zu vermeiden. Der Untersuchungsbereich kann dadurch gekennzeichnet sein, dass Rohdaten derart akquiriert werden, dass bei deren Rekonstruktion zu Bilddaten im Untersuchungsbereich befindliche Ausschnitte des Untersuchungsobjektes dargestellt werden. Der Untersuchungsbereich kann der Teilbereich des Magnetresonanzgerätes sein, von dem das Magnetresonanzgerät Rohdaten in guter Qualität erfassen kann. Der Untersuchungsbereich kann dadurch gekennzeichnet sein, dass das Magnetresonanzgerät dazu ausgebildet ist, innerhalb des Untersuchungsbereiches Rohdaten zu erfassen. Der Untersuchungsbereich kann auch als Sensitivitätsbereich des Magnetresonanzgerätes bezeichnet werden.

Bisherige Weiterentwicklungen für Gradientenspuleneinheiten betreffen hauptsächlich deren Kühlung, wie beispielsweise DE 10 2013 208 631 B3 und/oder DE 10 2011 083 204 A1.

Der Erfindung liegt die Aufgabe zugrunde, durch den Betrieb einer Gradientenspuleneinheit erzeugte Stimulationen in einem Untersuchungsobjekt zu reduzieren. Die Aufgabe wird durch die Merkmale der unabhängigen Ansprüche gelöst. Vorteilhafte Ausgestaltungen sind in den Unteransprüchen beschrieben.

Die Erfindung betrifft eine Lokalspuleneinheit zur Positionierung in einem von einer Gradientenspuleneinheit umgebenen Patientenaufnahmebereich umfassend eine Leiterstruktur umgebend einen Lokalbereich, wobei die Leiterstruktur dazu ausgebildet ist, im Lokalbereich ein lokales Magnetfeld zu erzeugen.

Der Patientenaufnahmebereich ist typischerweise durch den Innenraum eines hohlzylinderförmigen Magnetresonanzgerätes gekennzeichnet. Der Patientenaufnahmebereich ist derart ausgestaltet, dass typischerweise ein Untersuchungsobjekt innerhalb des Patientenaufnahmebereiches angeordnet werden kann. Die Gradientenspuleneinheit ist typischerweise integraler Bestandteil des Magnetresonanzgerätes, wodurch diese typischerweise den Patientenaufnahmebereich umgibt. Die Gradientenspuleneinheit ist typischerweise dazu ausgebildet, im Patientenaufnahmebereich zumindest einen globalen Magnetfeldgradienten zu erzeugen. Der globale Magnetfeldgradient ist insbesondere im Untersuchungsbereich besonders homogen. Der Untersuchungsbereich ist ein Teilbereich des Patientenaufnahmebereiches. Der Lokalbereich ist typischerweise ein Teilbereich des Patientenaufnahmebereiches. Der Lokalbereich und/oder die Lokalspuleneinheit sind vorzugsweise zumindest teilweise außerhalb des Patientenaufnahmebereiches angeordnet.

Die Lokalspuleneinheit ist typischerweise dazu ausgebildet, ein lokales Magnetfeld zu erzeugen. Die Lokalspuleneinheit kann dazu ausgebildet sein, das lokale Magnetfeld zeitabhängig zu erzeugen. Die Stärke des lokalen Magnetfeldes variiert typicherweis räumlich innerhalb des Lokalbereiches. Das lokale Magnetfeld kann ein lokaler Magnetfeldgradient sein. Die Leiterstruktur umfasst typischerweise einen elektrischen Leiter, in welchem abhängig von dem globalen Magnetfeldgradienten elektrischer Strom erzeugt wird. Dieser elektrische Strom kann aktiv durch eine angeschlossene elektrische Spannung erzeugt werden. Der elektrische Strom kann passiv, beispielsweise durch Induktion erzeugt werden. Insbesondere kann der globale Magnetfeldgradient einen elektrischen Strom in der Leiterstruktur induzieren. Die Leiterstruktur kann derart gewählt sein, dass ein durch den induzierten elektrischen Strom erzeugtes lokales Magnetfeld den globalen Magnetfeldgradienten im Lokalbereich reduziert und/oder minimiert und/oder kompensiert. Umfasst die Leiterstruktur einen elektrischen Leiter, so kann insbesondere ein gerichteter elektrischer Strom das lokale Magnetfeld erzeugen. Dies ermöglicht eine besonders genaue und effiziente Funktionsweise.

Unabhängig von der Anzahl der von der Lokalspuleneinheit umfassten Leiterstrukturen ist die Verlustleistung, die im Betrieb der Lokalspuleneinheit auftritt, geringer als die Verlustleistung der Gradientenspuleneinheit bei Erzeugung eines globalen Magnetfeldgradienten. Der Radius der hohlzylinderförmigen Lokalspuleneinheit beträgt typischerweise in etwa ein Drittel des Radius der hohlzylinderförmigen Gradientenspuleneinheit. Der Radius geht quadratisch in die Effizienz der Felderzeugung ein und mit vierter Potenz in die Verlustleistung. Dadurch beträgt eine im Betrieb der Lokalspuleneinheit entstehende Verlustleistung in etwa 1kW und/oder der technische Aufwand der Lokalspuleneinheit ist etwa eine Größenordnung geringer als bei einer Gradientenspuleneinheit.

Der Vorteil der erfindungsgemäßen Lokalspuleneinheit liegt darin, dass Phosphene reduziert werden können. Insbesondere können auch bei Gradientenspuleneinheiten, welche einen zur Aufnahme eines gesamten Körpers eines Untersuchungsobjektes ausgelegten Patientenaufnahmebereich umschließen und dazu ausgelegt sind, globale Magnetfeldgradienten mit Amplituden von mehr als 100mT/m zu erzeugen, Phosphene vermieden und/oder reduziert werden. Dies gilt insbesondere bei Untersuchungen an Körperregionen außerhalb des Kopfes. Dadurch ist eine Limitierung der maximalen Amplitude des Magnetfeldgradienten, insbesondere des globalen Magnetfeldgradienten, nicht erforderlich. Dadurch können auch bipolare Diffusionsverfahren in Körperregionen außerhalb des Kopfes mit globalen Magnetfeldgradienten mit Amplituden von mehr als 100 mT/m ausgeführt werden. Insbesondere kann die erfindungsgemäße Lokalspuleneinheit Stimulationen aufgrund des globalen Magnetfeldgradienten reduzieren und/oder minimieren.

Eine Ausführungsform der Lokalspuleneinheit sieht vor, dass die Lokalspuleneinheit dazu ausgebildet ist, das lokale Magnetfeld abhängig von einem von der Gradientenspuleneinheit im Patientenaufnahmebereich erzeugten globalen Magnetfeldgradienten zu erzeugen.
Hierfür ist die Lokalspuleneinheit typischerweise derart ausgelegt, dass diese dazu ausgebildet ist, synchron und/oder mit definiertem Phasenversatz mit der Gradientenspuleneinheit zu agieren. Dies ermöglicht eine besonders stabile Kompensation und/oder Reduktion des globalen Magnetfeldgradienten im Lokalbereich. Insbesondere kann das lokale Magnetfeld analog zum globalen Magnetfeldgradienten erzeugt werden, wodurch die zeitliche Variation des globalen Magnetfeldgradienten auf das lokale Magnetfeld, insbesondere auf einen lokalen Magnetfeldgradienten, übertragen werden kann.

Eine Ausführungsform der Lokalspuleneinheit sieht vor, dass die Leiterstruktur derart geformt ist, dass diese auf einer Mantelfläche eines Zylinders anzuordnen ist. Eine derartige Lokalspuleneinheit weist eine besonders hohe Effizienz auf. Insbesondere kann eine derartige Lokalspuleneinheit einen Hohlraum zur Aufnahme von einem Kopf und/oder Brustkorb des Untersuchungsobjektes ausgelegt sein.

Der Lokalbereich ist vorzugsweise zylinderförmig ausgestaltet. Der Zylinder ist vorzugsweise ein Kreiszylinder oder ein elliptischer Zylinder. Ein elliptischer Zylinder kann besonders vorteilhaft einen Brustkorb des Untersuchungsobjektes umschließen und im Bereich des Herzens einen weitgehend homogenen lokalen Magnetfeldgradienten als lokales Magnetfeld zu erzeugen. Insbesondere kann eine definierte räumliche Variation der Stärke des lokalen Magnetfeldes besonders genau realisiert werden. Ein Kreiszylinder kann besonders vorteilhaft einen Kopf des Untersuchungsobjektes umschließen und im Bereich des Gehirns und/oder der Augen einen weitgehend homogenen lokalen Magnetfeldgradienten als lokales Magnetfeld erzeugen. Dadurch können Stimulationen besonders effizient vermieden werden.

Eine Ausführungsform der Lokalspuleneinheit sieht vor, dass die Leiterstruktur derart gewählt ist, dass innerhalb des von der Leiterstruktur umgebenen Lokalbereiches ein Kopf und/oder ein Brustkorb eines Untersuchungsobjektes positionierbar ist.

Dies ermöglicht die Unterdrückung von Stimulationen im Bereich des Gehirns und/oder der Augen, wodurch Phosphene unterdrückt werden können. Starke Magnetfeldgradienten im Bereich des Herzens können zu Extrasystolen führen, welche durch die erfindungsgemäße Lokalspuleneinheit vermieden werden können. Insbesondere kann die rechnerische Wahrscheinlichkeit für das Auftreten einer Extrasystole auf einen normativ geforderten Wert reduziert werden, welcher typischerweise bei typisch P<10^-12 liegt. Die Lokalspuleneinheit kann folglich analog zu lokalen Empfangsspulen von Magnetresonanzgeräten speziell für eine Körperregion ausgelegt sein.

Eine Ausführungsform der Lokalspuleneinheit sieht vor, dass die Leiterstruktur einen zumindest teilweise spiralförmig angeordneten elektrischen Leiter umfasst. Eine derartig ausgebildete Leiterstruktur ist insbesondere dazu geeignet, einen lokalen Magnetfeldgradienten als lokales Magnetfeld entlang der z-Richtung des Lokalbereiches zu erzeugen. Zudem kann ein gerichteter elektrischer Strom fließen. Dies ermöglicht eine besonders effiziente Erzeugung des lokalen Magnetfeldes. Eine derartige Leiterstruktur kann aktiv mit elektrischen Strom versorgt werden. Eine derartige Leiterstruktur kann passiv, beispielsweise mittels Induktion, einen elektrischen Strom leiten.

Eine Ausführungsform der Lokalspuleneinheit sieht vor, dass die Leiterstruktur dazu ausgebildet ist, im Lokalbereich einen linearen lokalen Magnetfeldgradienten als lokales Magnetfeld in eine erste Raumrichtung zu erzeugen. Die erste Raumrichtung ist vorzugsweise parallel zur Längsachse des Patientenaufnahmebereiches und/oder des Lokalbereiches, insbesondere parallel zur z-Achse des Magnetresonanzgerätes, welches die Gradientenspuleneinheit umfasst. Die erste Richtung entspricht vorzugsweise der longitudinalen Richtung des Patientenaufnahmebereiches und/oder des Lokalbereiches. Die Gradientenspuleneinheit umfasst typischerweise drei Gradientenleiterstrukturen zur Erzeugung von globalen Magnetfeldgradienten in drei voneinander verschiedene Raumrichtungen. Bei jedem von einer der drei Gradientenleiterstrukturen erzeugten globalen Magnetfeldgradienten beträgt der Anteil der Komponente entlang der z-Achse zumindest 50%. Dadurch ermöglicht eine Leiterstruktur, welche zur Erzeugung eines lokalen Magnetfeldgradienten entlang der z-Achse ausgelegt ist, eine effiziente lokale Kompensation des globalen Magnetfeldgradienten. Insbesondere ist in diesem Fall ausreichend, wenn die Leiterstruktur als Solenoidspule ausgebildet ist. Eine derartige Leiterstruktur kann besonders einfach gefertigt und/oder betrieben werden. Insbesondere ist für die Ansteuerung einer Leiterstruktur nur eine Spannungsquelle erforderlich.

Eine Ausführungsform der Lokalspuleneinheit sieht vor, dass die Lokalspuleneinheit zumindest zwei Leiterstrukturen umfasst, wobei eine erste Leiterstruktur der zumindest zwei Leiterstrukturen dazu ausgebildet ist, einen linearen lokalen Magnetfeldgradienten in eine erste Raumrichtung zu erzeugen und eine zweite Leiterstruktur der zumindest zwei Leiterstrukturen dazu ausgebildet ist, einen linearen lokalen Magnetfeldgradienten in eine zweite Raumrichtung zu erzeugen. Jede der von der Lokalspuleneinheit umfassten Leiterstruktur ist vorzugsweise mit einer eigenen Spannungsquelle verbunden. Die zweite Richtung ist typischerweise orthogonal zur ersten Richtung. Die Lokalspuleneinheit umfasst vorzugsweise eine dritte Leiterstruktur zur Erzeugung eines linearen lokalen Magnetfeldgradienten in eine dritte Raumrichtung. Die dritte Raumrichtung ist vorzugsweise orthogonal zu der ersten Raumrichtung und der zweiten Raumrichtung. Vorzugweise entspricht die Anzahl der von der Lokalspuleneinheit umfassten Leiterstrukturen der Anzahl der von der Gradientenspuleneinheit umfassten Gradientenleiterstrukturen.
Das lokale Magnetfeld kann eine Kombination des linearen lokalen Magnetfeldgradienten in die erste Raumrichtung und/oder des linearen lokalen Magnetfeldgradienten in die zweite Raumrichtung und/oder des linearen lokalen Magnetfeldgradienten in die dritte Raumrichtung sein.

Dadurch kann der globale Magnetfeldgradient unabhängig von dessen Richtung und/oder Dauer im Lokalbereich besonders gut kompensiert werden. Mit steigender Anzahl an Leiterstrukturen können lokale Magnetfeldgradienten in eine steigende Anzahl an Raumrichtungen erzeugt werden. Dadurch können globale Magnetfeldgradienten lokal besonders genau kompensiert werden. Dadurch kann die Lokalspuleneinheit besonders gut Stimulationen am Untersuchungsobjekt unterdrücken.

Eine Ausführungsform der Lokalspuleneinheit sieht vor, dass die Lokalspuleneinheit eine Kühlvorrichtung umfasst. Die Kühlvorrichtung ist vorzugsweise bifilar. Die Kühlvorrichtung umfasst vorzugsweise eine hohlförmige Vorrichtung zum Transport eines Kühlmediums, beispielsweise einer Flüssigkeit. Die Kühlvorrichtung ist vorzugsweise dazu ausgebildet, eine im Betrieb der Lokalspuleneinheit entstehende Verlustleistung abzuführen. Dadurch kann eine Erwärmung der Lokalspuleneinheit, welche typischerweise nahe des Untersuchungsobjektes angeordnet ist, reduziert und/oder limitiert werden. Insbesondere können dadurch normierte Grenzwerte für die Temperatur eingehalten werden.

Eine Ausführungsform der Lokalspuleneinheit sieht vor, dass die Leiterstruktur vergossen ist.
Der Verguss kann beispielsweise aus Epoxid und/oder Harz sein. Ein Verguss der Leiterstruktur kann die durch rasche Wechsel der Stromrichtung mit hohen Anstiegs- und Abfallraten im Betrieb der Lokalspuleneinheit entstehende Lorenzkräfte dämpfen. Dadurch kann die Lautstärke der Lokalspuleneinheit reduziert werden. Ebenso wird die Bewegung und/oder Vibration der Lokalspuleneinheit reduziert, was einen sicheren und genauen Betrieb der Lokalspuleneinheit ermöglicht.

Eine alternative Ausführungsform der Lokalspuleneinheit zur Positionierung in einem von einer Gradientenspuleneinheit umgebenen Patientenaufnahmebereich umfassend eine Leiterstruktur umgebend einen Lokalbereich sieht vor, dass die Leiterstruktur dazu ausgebildet ist, im Lokalbereich einen globalen Magnetfeldgradienten abzuschirmen, wobei die Leiterstruktur als Hohlzylinder aus Metall ausgebildet ist. Das Metall ist vorzugsweise Kupfer. Diese Ausführungsform der Lokalspuleneinheit wirkt vorzugsweise passiv. Insbesondere können durch einen globalen Magnetfeldgradienten und/oder durch einen Hochfrequenzpuls Wirbelströme erzeugt werden. Die Wirbelströme können einerseits im Lokalbereich ein lokales Magnetfeld zur Abschirmung des globalen Magnetfeldgradienten erzeugen. Ebenso kann die Leiterstruktur gemäß dieser Ausführungsform ein Eindringen des globalen Magnetfeldgradienten in den Lokalbereich verhindern. Die Wirbelströme können im Lokalbereich als Tiefpassfilter auf den Amplituden-Zeit Verlauf des globalen Magnetfeldgradienten wirken. Diese Ausführungsform der Lokalspuleneinheit ist vorzugsweise nicht mit einer Spannungsquelle verbunden. Diese Ausführungsform der Lokalspuleneinheit ist typischerweise besonders einfach installierbar. Ebenso können bestehende Magnetresonanzgeräte mit einer derartigen Ausführungsform der Lokalspuleneinheit nachgerüstet werden. Diese Ausführungsform der Lokalspuleneinheit umfasst vorzugsweise eine Kühlvorrichtung, beispielsweise eine hohlförmige Vorrichtung zum Transport eines Kühlmediums. Dadurch kann die in der Lokalspuleneinheit entstehende Wärme aufgrund von Wirbelströmen kann dadurch abgeführt werden. Der Vorteil dieser Ausführungsform liegt darin, dass kein Eingriff in die Steuerung des Magnetresonanzgerätes, insbesondere in die Steuerung der Gradientenspuleneinheit erforderlich ist. Ebenso können bestehende Magnetresonanzgeräte mit einer derartigen Lokalspuleneinheit besonders einfach nachgerüstet werden.

Eine Ausführungsform der Lokalspuleneinheit sieht vor, dass der Hohlzylinder zumindest eine Aussparung aufweist. Die Aussparung umfasst vorzugsweise zumindest einen Teilbereich des Hohlzylinders. Die Dicke der Aussparung entspricht vorzugsweise der radialen Dicke des Hohlzylinders. Die Aussparung weist vorzugsweise eine derartige Größe und/oder Position auf, dass diese ein Sichtfeld von innerhalb des Lokalbereiches positionierten Augen außerhalb des Lokalbereichs ermöglichen. Die Aussparung ist demnach typischerweise ein Luftschlitz im Hohlzylinder. Effekte aufgrund einer Wechselwirkung der Lokalspuleneinheit mit den globalen Magnetfeldgradienten aufgrund der Aussparung können anhand finiter Elemente Berechnungen bestimmt werden und/oder iterativ optimiert werden. Diese Ausführungsform der Lokalspuleneinheit erhöht den Komfort für das Untersuchungsobjekt.

Eine Ausführungsform der Lokalspuleneinheit sieht vor, dass die Leiterstruktur eine Zeitkonstante von zumindest 10 ms aufweist. Eine derartige Zeitkonstante zum Abklingen der induzierten Wirbelströme entspricht den stimulationsempfindlichen Frequenzen für Phosphene bei weniger als 100Hz. Dadurch können die für Phosphene verantwortlichen Teile eines globalen Magnetfeldgradienten besonders effizient eliminiert werden.

Eine Ausführungsform der Lokalspuleneinheit sieht vor, dass der Hohlzylinder eine Dicke zwischen 0,5 cm und 3,0 cm, besonders bevorzugt zwischen 1,0 cm und 2,0 cm aufweist. Diese Dicke ermöglicht eine besonders effiziente Abschirmung bei zugleich kompakter Bauweise.

Des Weiteren geht die Erfindung aus von einem Lokalspulensystem umfassend eine erfindungsgemäße Lokalspuleneinheit, eine Spulensteuereinheit mit einer Ermittlungseinheit und einer Erfassungseinheit,
wobei die Erfassungseinheit dazu ausgebildet ist, eine erste Information über einen globalen Magnetfeldgradienten im Patientenaufnahmebereich zu empfangen,
die Ermittlungseinheit dazu ausgebildet ist, abhängig von der ersten Information eine Steuerinformation zu ermitteln,
die Spulensteuereinheit dazu ausgebildet ist, die Lokalspuleneinheit gemäß der Steuerinformation anzusteuern, wobei das lokale Magnetfeld erzeugt wird.

Die erste Information über einen globalen Magnetfeldgradienten kann ein zeitlicher Verlauf und/oder eine Amplitude des globalen Magnetfeldgradienten sein. Die erste Information können Ansteuerungsdaten des Magnetresonanzgerätes umfassen und/oder ein daraus extrahierter zeitlicher Verlauf eines globalen Magnetfeldgradienten. Die erste Information kann prospektiv sein. Die erste Information kann auch experimentell erfasst werden und/oder einen aktuellen Wert für einen globalen Magnetfeldgradienten angeben. Die Erfassungseinheit kann dazu ausgebildet sein, die erste Information zu empfangen und/oder zu ermitteln. Die erste Information über einen globalen Magnetfeldgradienten umfasst insbesondere eine Information über einen globalen Magnetfeldgradienten innerhalb des Lokalbereiches.

Die Steuerinformation ist beispielsweise eine zeitabhängige Spannung und/oder ein zeitabhängiger elektrischer Strom, mit dem die Lokalspuleneinheit angesteuert wird. Der Ermittlungseinheit werden vorzugsweise Daten hinsichtlich eines Zusammenhangs zwischen einer Steuerinformation und einem von der Lokalspuleneinheit durch diese Steuerinformation erzeugten lokalen Magnetfeldes bereitgestellt, beispielsweise in Form einer Funktion und/oder einer Wertetabelle. Die Ermittlung der Steuerinformation abhängig von der ersten Information berücksichtigt vorzugsweise derartige Daten.

Die Lokalspuleneinheit ist vorzugsweise mit der Spulensteuereinheit verbunden, vorzugsweise mittels eines leistungsfesten Steckers. Die Spulensteuereinheit weist typischerweise einen Eingang, eine Prozessoreinheit und einen Ausgang auf. Über den Eingang können der Spulensteuereinheit im Verfahren benötigte Funktionen, Algorithmen oder Parameter bereitgestellt werden. Die Steuerinformation und weitere Daten können über den Ausgang bereitgestellt werden. Die Spulensteuereinheit kann in das Magnetresonanzgerät integriert sein. Die Spulensteuereinheit kann auch separat von dem Magnetresonanzgerät installiert sein. Die Spulensteuereinheit kann mit dem Magnetresonanzgerät verbunden sein.

Die Spulensteuereinheit kann dazu ausgebildet sein, Steuerungssignale zu senden und/oder Steuerungssignale zu empfangen und/oder zu verarbeiten, um die erste Information zu empfangen und/oder abhängig von der ersten Information eine Steuerinformation zu ermitteln. Auf einer Speichereinheit der Spulensteuereinheit können Computerprogramme und weitere Software gespeichert sein, mittels derer die Prozessoreinheit der Spulensteuereinheit einen Verfahrensablauf eines erfindungsgemäßen Verfahrens automatisch steuert und/oder ausführt.

Eine Ausführungsform des Lokalspulensystems sieht vor, dass die Ermittlungseinheit dazu ausgebildet ist, die Steuerinformation derart zu ermitteln, dass ein bei Ansteuerung der Leiterstruktur gemäß der Steuerinformation erzeugtes lokales Magnetfeld den globalen Magnetfeldgradienten im Lokalbereich reduziert und/oder kompensiert. Im Lokalbereich kommt es bei Erzeugung des lokalen Magnetfeldes zu einer Überlagerung des lokalen Magnetfeldes mit dem globalen Magnetfeldgradienten. Das lokale Magnetfeld, vorzugsweise ausgestaltet als lokaler Magnetfeldgradient, ist vorzugsweise derart ausgestaltet, dass im Lokalbereich und/oder in einem Teilbereich des Lokalbereiches der globale Magnetfeldgradient reduziert und/oder kompensiert wird. Die Ermittlungseinheit umfasst vorzugsweise einen Optimierungsalgorithmus, der eine Überlagerung des lokalen Magnetfeldes mit dem globalen Magnetfeldgradienten simuliert und/oder minimiert. Die Steuerinformation ist vorzugsweise derart gewählt, dass es zu einer destruktiven Überlagerung kommt und/oder das lokale Magnetfeld ein invers zum globalen Magnetfeldgradienten ausgestalteter lokaler Magnetfeldgradient ist.

Eine Ausführungsform des Lokalspulensystems sieht vor, dass das Lokalspulensystem eine erste Sensoreinheit zum Erfassen der ersten Information umfasst. Die erste Sensoreinheit kann dazu ausgebildet sein, den globalen Magnetfeldgradienten an definierten Positionen innerhalb des Patientenaufnahmebereiches, vorzugsweise innerhalb des Lokalbereiches, experimentell zu ermitteln. Eine derartige erste Information umfasst einen aktuellen, tatsächlich erzeugten Wert, welcher der Spulensteuereinheit bereitgestellt werden kann. Darauf basierend kann die S Ermittlungseinheit die Steuerinformation besonders genau ermitteln.

Eine Ausführungsform des Lokalspulensystems sieht vor, dass das Lokalspulensystem eine zweite Sensoreinheit zur Erfassung einer zweiten Information an zumindest einer Position innerhalb des Lokalbereiches umfasst. Die zweite Sensoreinheit ist vorzugsweise innerhalb des Lokalbereiches angeordnet. Die zweite Sensoreinheit ist vorzugsweise dazu ausgebildet, als zweite Information eine Stärke eines Magnetfeldes, insbesondere einer Überlagerung des lokalen Magnetfeldes und des globalen Magnetfeldgradienten und/oder des Hauptmagnetfeldes zu ermitteln.
Die zweite Sensoreinheit kann auch dazu ausgebildet sein, als zweite Information eine Temperatur zu erfassen.

Die zweite Sensoreinheit ist vorzugsweise mit der Ermittlungseinheit verbunden, wobei die Ermittlungseinheit dazu ausgebildet ist, bei Ermittlung der Steuerinformation die zweite Information zu berücksichtigen.

Gemäß dieser Ausführungsform kann insbesondere die Überlagerung des lokalen Magnetfeldes und des globalen Magnetfeldgradienten überwacht werden und kontrolliert werden, ob lokal Erhöhungen bei der Überlagerung entstehen. Die Ermittlungseinheit kann dazu ausgebildet sein, die zweite Information mit einem Schwellwert zu vergleichen und bei Überschreitung des Schwellwertes eine Abschaltung des Lokalspulensystems zu veranlassen. Die Position der Lokalspuleneinheit kann beispielsweise durch eine mechanische Kodierung auf der Patientenlagerungsvorrichtung definiert werden. Dadurch ist auch eine komplexe Positionserkennung möglich.

Des Weiteren geht die Erfindung aus von einem Spulensystem umfassend ein erfindungsgemäßes Lokalspulensystem, eine Gradientenspuleneinheit und eine Gradientensteuereinheit zur Ansteuerung der zumindest einen Gradientenspuleneinheit. Das Spulensystem ist zur Ausführung eines erfindungsgemäßen Verfahrens ausgelegt. Die Gradientensteuereinheit kann gemeinsam mit der Spulensteuereinheit eine Einheit bilden. Die Gradientensteuereinheit kann separat von der Spulensteuereinheit ausgebildet sein. Die Gradientensteuereinheit ist vorzugsweise mit der Spulensteuereinheit verbunden. Die Gradientensteuereinheit kann in das Magnetresonanzgerät integriert sein. Die Gradientensteuereinheit kann auch separat von dem Magnetresonanzgerät installiert sein. Die Gradientensteuereinheit kann mit dem Magnetresonanzgerät verbunden sein. Das Spulensystem kann in das Magnetresonanzgerät integriert sein. Die Gradientensteuereinheit kann auch separat von dem Spulensystem installiert sein.

Eine Ausführungsform des Spulensystems sieht vor, dass die Lokalspuleneinheit zumindest teilweise außerhalb eines Untersuchungsbereiches angeordnet ist. Der Vorteil dieser Ausführung liegt darin, dass eine Wechselwirkung der Lokalspuleneinheit mit dem globalen Magnetfeldgradienten und/oder Hochfrequenzfeld überwiegend außerhalb des Untersuchungsbereiches erfolgt. Eine Auswirkung der Wechselwirkung auf den Untersuchungsbereich wird limitiert. Dadurch wird eine Aufnahme von Rohdaten im Untersuchungsbereich nur gering beeinflusst. Zudem kann die Leiterstruktur und/oder die Lokalspuleneinheit derart ausgestaltet sein, dass die Wechselwirkung reduziert wird. Beispielsweise können durch eine definierte Aussparung der Leiterstruktur und/oder durch einen zusätzlichen elektrischen Leiter, welcher bei Bedarf aktiv gesteuert wird, eine Wechselwirkung reduziert werden.

Des Weiteren geht die Erfindung aus von einem Magnetresonanzgerät umfassend ein erfindungsgemäßes Spulensystem, einen Hauptmagneten, eine Hochfrequenzantenneneinheit, wobei das Magnetresonanzgerät zu einer Ausführung eines erfindungsgemäßen Verfahrens und zu einer Akquisition von Rohdaten ausgelegt ist. Das Magnetresonanzgerät umfasst typischerweise eine Steuereinheit, welche die Gradientensteuereinheit und/oder die Spulensteuereinheit umfassen kann.

Des Weiteren geht die Erfindung aus von einem Verfahren zu einer Reduzierung eines von einer Gradientenspuleneinheit erzeugten globalen Magnetfeldgradienten in einem Lokalbereich durch Erzeugung eines lokalen Magnetfeldes mittels eines erfindungsgemäßen Lokalspulensystems gemäß den folgenden Verfahrensschritten:
- Erfassung einer ersten Information über einen globalen Magnetfeldgradienten im Patientenaufnahmebereich
- Ermittlung einer Steuerinformation abhängig von der ersten Information
- Ansteuerung der Leiterstruktur gemäß der Steuerinformation und dadurch
- Erzeugung eines lokalen Magnetfeldes im Lokalbereich in Abhängigkeit des globalen Magnetfeldgradienten.

Ausführungsformen des erfindungsgemäßen Magnetresonanzgeräts, des erfindungsgemäßen Spulensystems, des erfindungsgemäßen Lokalspulensystems und des erfindungsgemäßen Verfahrens sind analog zu den Ausführungsformen der erfindungsgemäßen Lokalspuleneinheit ausgebildet. Das Magnetresonanzgerät kann dazu ausgebildet sein, Steuerungssignale zu senden und/oder Steuerungssignale zu empfangen und/oder zu verarbeiten, um ein erfindungsgemäßes Verfahren auszuführen. Auf einer Speichereinheit der Steuereinheit können Computerprogramme und weitere Software gespeichert sein, mittels derer die Prozessoreinheit der Steuereinheit einen Verfahrensablauf eines erfindungsgemäßen Verfahrens automatisch steuert und/oder ausführt. Die Vorteile des erfindungsgemäßen Magnetresonanzgeräts, des erfindungsgemäßen Spulensystems, des erfindungsgemäßen Lokalspulensystems und des erfindungsgemäßen Verfahrens entsprechen im Wesentlichen den Vorteilen der erfindungsgemäßen Lokalspuleneinheit, welche vorab im Detail ausgeführt sind. Hierbei erwähnte Merkmale, Vorteile oder alternative Ausführungsformen können ebenso auch auf die anderen beanspruchten Gegenstände übertragen werden und umgekehrt.

Weitere Vorteile, Merkmale und Einzelheiten der Erfindung ergeben sich aus den im Folgenden beschriebenen Ausführungsbeispielen sowie anhand der Zeichnungen.

Es zeigen:
- Fig. 1: ein erfindungsgemäßes Magnetresonanzgerät in einer schematischen Darstellung,
- Fig. 2: eine erste Ausführungsform einer erfindungsgemäßen Lokalspuleneinheit in einer schematischen Darstellung,
- Fig. 3: eine zweite Ausführungsform einer erfindungsgemäßen Lokalspuleneinheit in einer schematischen Darstellung,
- Fig. 4: eine erste Ausführungsform eines erfindungsgemäßen Spulensystems mit einer ersten Ausführungsform eines erfindungsgemäßen Lokalspulensystems in einer schematischen Darstellung,
- Fig. 5: eine zweite Ausführungsform eines erfindungsgemäßen Spulensystems mit einer zweiten Ausführungsform eines erfindungsgemäßen Lokalspulensystems in einer schematischen Darstellung, und
- Fig. 6: Ablaufdiagramm eines erfindungsgemäßen Verfahrens.

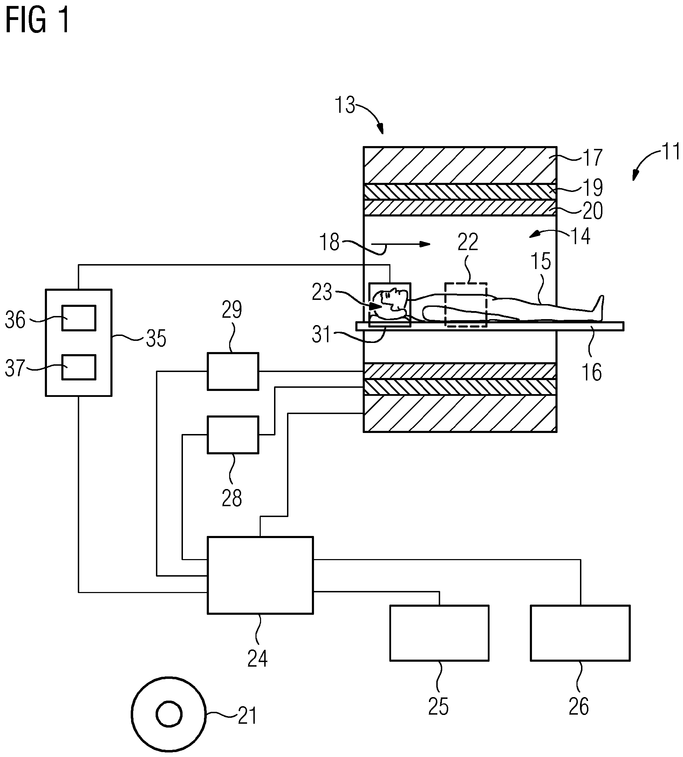

Figur 1 zeigt ein erfindungsgemäßes Magnetresonanzgerät 11 in einer schematischen Darstellung. Das Magnetresonanzgerät 11 umfasst eine von einer Magneteinheit 13 gebildeten Detektoreinheit mit einem Hauptmagneten 17 zu einem Erzeugen eines starken und insbesondere konstanten Hauptmagnetfelds 18. Zudem weist das Magnetresonanzgerät 11 einen zylinderförmigen Patientenaufnahmebereich 14 zu einer Aufnahme eines Patienten 15 auf, wobei der Patientenaufnahmebereich 14 in einer Umfangsrichtung von der Magneteinheit 13 zylinderförmig umschlossen ist. Der Patient 15 kann mittels einer Patientenlagerungsvorrichtung 16 des Magnetresonanzgeräts 11 in den Patientenaufnahmebereich 14 geschoben werden. Die Patientenlagerungsvorrichtung 16 weist hierzu einen Patiententisch auf, der bewegbar innerhalb des Magnetresonanzgeräts 11 angeordnet ist. Innerhalb des Patientenaufnahmebereiches 14 ist der Untersuchungsbereich 22 angeordnet. Das Magnetresonanzgeräts 11 ist typischerweise dazu ausgebildet, Rohdaten von den im Untersuchungsbereich 22 angeordneten Teil des Patienten 15 aufzunehmen.

Die Magneteinheit 13 weist weiterhin eine Gradientenspuleneinheit 19 auf, die für eine Ortskodierung während einer Bildgebung verwendet werden. Die Gradientenspuleneinheit 19 wird mittels einer Gradientensteuereinheit 28 angesteuert. Des Weiteren weist die Magneteinheit 13 eine Hochfrequenzantenneneinheit 20, welche im gezeigten Fall als fest in das Magnetresonanzgerät 11 integrierte Körperspule ausgebildet ist, und eine Hochfrequenzantennensteuereinheit 29 zu einer Anregung einer Polarisation, die sich in dem von dem Hauptmagneten 17 erzeugten Hauptmagnetfeld 18 einstellt, auf. Die Hochfrequenzantenneneinheit 20 wird von der Hochfrequenzantennensteuereinheit 29 angesteuert und strahlt hochfrequente Hochfrequenz-Pulse in einen Untersuchungsraum, der im Wesentlichen von dem Patientenaufnahmebereich 14 gebildet ist, ein.

Zu einer Steuerung des Hauptmagneten 17, der Gradientensteuereinheit 28 und der Hochfrequenzantennensteuereinheit 29 weist das Magnetresonanzgerät 11 eine Steuerungseinheit 24 auf. Die Steuerungseinheit 24 steuert zentral das Magnetresonanzgerät 11, wie beispielsweise das Durchführen von MR-Steuerungssequenzen. Zudem umfasst die Steuerungseinheit 24 eine nicht näher dargestellte Rekonstruktionseinheit zu einer Rekonstruktion von medizinischen Bilddaten, die während der Magnetresonanzuntersuchung erfasst werden. Das Magnetresonanzgerät 11 weist eine Anzeigeeinheit 25 auf. Steuerinformationen wie beispielsweise Steuerungsparameter, sowie rekonstruierte Bilddaten können auf der Anzeigeeinheit 25, beispielsweise auf zumindest einem Monitor, für einen Benutzer angezeigt werden. Zudem weist das Magnetresonanzgerät 11 eine Eingabeeinheit 26 auf, mittels derer Informationen und/oder Steuerungsparameter während eines Messvorgangs von einem Benutzer eingegeben werden können. Die Steuerungseinheit 24 kann die Gradientensteuereinheit 28 und/oder Hochfrequenzantennensteuereinheit 29 und/oder die Anzeigeeinheit 25 und/oder die Eingabeeinheit 26 umfassen.

Das Magnetresonanzgerät 11 umfasst ein Lokalspulensystem 38, welches eine Lokalspuleneinheit 31, eine Spulensteuereinheit 35 mit einer Ermittlungseinheit 36 und einer Erfassungseinheit 37 umfasst. Die Lokalspuleneinheit 31 ist im Patientenaufnahmebereich 14 angeordnet und umgibt einen Lokalbereich 23. Der Lokalbereich 23 außerhalb des Untersuchungsbereiches 22 angeordnet. Die Lokalspuleneinheit 31, 41 ist außerhalb des Untersuchungsbereiches 22 angeordnet. Die Spulensteuereinheit 35 kann auch in die Steuerungseinheit 24 und/oder in die Gradientensteuereinheit 28 integriert sein. Das Magnetresonanzgerät 11 ist gemeinsam mit dem Lokalspulensystem 38 zu einer Ausführung eines Verfahren zu einer Reduzierung eines von der Gradientenspuleneinheit 19 erzeugten globalen Magnetfeldgradienten in dem Lokalbereich 23 durch Erzeugung eines lokalen Magnetfeldes ausgebildet.

Hierzu weist die Spulensteuereinheit 35 Computerprogramme und/oder Software auf, die direkt in einem nicht näher dargestellten Speichereinheit der Spulensteuereinheit 35 ladbar sind, mit Programmmitteln, um ein Verfahren zu einer Reduzierung eines von der Gradientenspuleneinheit 19 erzeugten globalen Magnetfeldgradienten auszuführen, wenn die Computerprogramme und/oder Software in der Spulensteuereinheit 35 ausgeführt werden. Die Spulensteuereinheit 35 weist hierzu einen nicht näher dargestellten Prozessor auf, der zu einer Ausführung der Computerprogramme und/oder Software ausgelegt ist. Alternativ hierzu können die Computerprogramme und/oder Software auch auf einem getrennt von der Steuerungseinheit 24 und/oder Spulensteuereinheit 35 ausgebildeten elektronisch lesbaren Datenträger 21 gespeichert sein, wobei ein Datenzugriff von der Spulensteuereinheit 35 auf den elektronisch lesbaren Datenträger 21 über ein Datennetz erfolgen kann.

Das dargestellte Magnetresonanzgerät 11 kann selbstverständlich weitere Komponenten umfassen, die Magnetresonanzgeräte 11 gewöhnlich aufweisen. Eine allgemeine Funktionsweise eines Magnetresonanzgeräts 11 ist zudem dem Fachmann bekannt, so dass auf eine detaillierte Beschreibung der weiteren Komponenten verzichtet wird. Das Magnetresonanzgerät 11 ist somit zusammen mit dem Lokalspulensystem 38 zur Ausführung eines erfindungsgemäßen Verfahrens ausgelegt. Ein Verfahren zu einer lokalen Reduzierung eines von der Gradientenspuleneinheit 19 erzeugten globalen Magnetfeldgradienten kann auch in Form eines Computerprogrammprodukts vorliegen, das das Verfahren auf die Spulensteuereinheit 35 implementiert, wenn es auf der Spulensteuereinheit 35 ausgeführt wird. Ebenso kann ein elektronisch lesbarer Datenträger 21 mit darauf gespeicherten elektronisch lesbaren Steuerinformationen vorliegen, welche zumindest ein solches eben beschriebenes Computerprogrammprodukt umfassen und derart ausgestaltet sind, dass sie bei Verwendung des Datenträgers 21 in einer Spulensteuereinheit 35 eines Magnetresonanzgeräts 11 das beschriebene Verfahren durchführen.

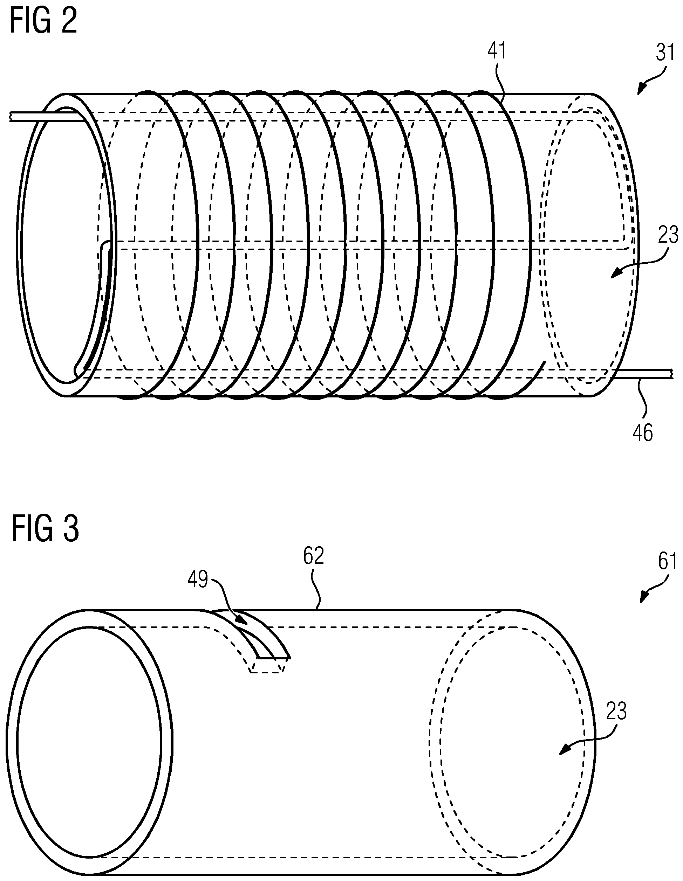

Figur 2 zeigt eine erste Ausführungsform einer erfindungsgemäßen Lokalspuleneinheit 31 in einer schematischen Darstellung. Die Lokalspuleneinheit 31 umfasst eine Leiterstruktur 41, welche einen Lokalbereich 23 umgibt und dazu ausgebildet ist, im Lokalbereich 23 ein lokales Magnetfeld zu erzeugen.

Die Leiterstruktur 41 ist derart geformt ist, dass diese auf einer Mantelfläche eines Zylinders anzuordnen ist.
Die Leiterstruktur 14 ist derart gewählt ist, dass innerhalb des von der Leiterstruktur 41 umgebenen Lokalbereiches 23 ein Kopf und/oder ein Brustkorb eines Untersuchungsobjektes 15 positionierbar ist. Die Leiterstruktur 41 umfasst einen zumindest teilweise spiralförmig angeordneten elektrischen Leiter, welcher dazu ausgebildet ist, im Lokalbereich 23 einen linearen lokalen Magnetfeldgradienten in eine erste Raumrichtung als lokales Magnetfeld zu erzeugen. Des Weiteren umfasst die Lokalspuleneinheit 31 vorzugsweise eine Kühlvorrichtung 46.

Figur 3 zeigt eine zweite Ausführungsform einer erfindungsgemäßen Lokalspuleneinheit 61 in einer schematischen Darstellung. Die zweite Ausführungsform der erfindungsgemäßen Lokalspuleneinheit 61
kann innerhalb eines von einer Gradientenspuleneinheit 19 umgebenen Patientenaufnahmebereichs 14 positioniert werden. Die Lokalspuleneinheit 61 umfasst eine Leiterstruktur 62 umgebend einen Lokalbereich 23, wobei die Leiterstruktur 62 als Hohlzylinder aus Metall ausgebildet ist. Die Leiterstruktur 62 ist dazu ausgebildet ist, im Lokalbereich 23 einen globalen Magnetfeldgradienten abzuschirmen. Der Hohlzylinder weist vorzugsweise zumindest eine Aussparung 49 auf. Die radiale Dicke des Hohlzylinders beträgt vorzugsweise zwischen 0,5 cm und 3,0 cm, besonders bevorzugt zwischen 1,0 cm und 2,0 cm. Zudem ist das Material des Hohlzylinders vorzugsweise derart gewählt, dass die Leiterstruktur 41 eine Zeitkonstante von zumindest 10 ms aufweist.

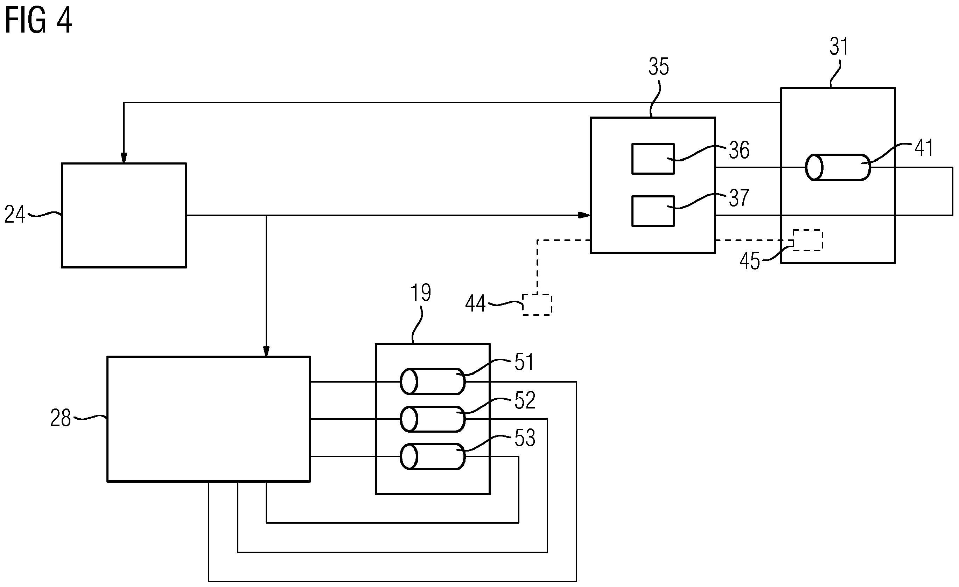

Figur 4 zeigt eine erste Ausführungsform eines erfindungsgemäßen Spulensystems mit einer ersten Ausführungsform eines erfindungsgemäßen Lokalspulensystems 38 in einer schematischen Darstellung. Die erste Ausführungsform des Lokalspulensystems 38 umfasst eine erste Ausführungsform einer Lokalspuleneinheit 31, eine Spulensteuereinheit 35 mit einer Ermittlungseinheit 36 und einer Erfassungseinheit 37. Die Erfassungseinheit 37 ist dazu ausgebildet, eine erste Information über einen globalen Magnetfeldgradienten im Patientenaufnahmebereich 14 zu empfangen. Die Ermittlungseinheit 36 ist dazu ausgebildet, abhängig von der ersten Information eine Steuerinformation zu ermitteln. Die Ermittlungseinheit 36 ist vorzugsweise dazu ausgebildet, die Steuerinformation derart zu ermitteln, dass ein bei Ansteuerung der Lokalspuleneinheit 31 gemäß der Steuerinformation erzeugten lokalen Magnetfeldes den globalen Magnetfeldgradienten im Lokalbereich 23 reduziert und/oder eliminiert. Die Spulensteuereinheit 35 ist dazu ausgebildet, die Lokalspuleneinheit 31 gemäß der Steuerinformation anzusteuern, wobei ein lokales Magnetfeld erzeugt wird. Hierdurch ist die Lokalspuleneinheit 31 dazu ausgebildet, das lokale Magnetfeld abhängig von einem von der Gradientenspuleneinheit 19 im Patientenaufnahmebereich 14 erzeugten globalen Magnetfeldgradienten zu erzeugen.

Das Lokalspulensystem 38 umfasst optional eine erste Sensoreinheit 44 zum Erfassen der ersten Information. Die erste Sensoreinheit 44 ist vorzugsweise in einem vom Magnetresonanzgerät 11 umschlossenen Pataufnahmebereich 14 abgeordnet. Das Lokalspulensystem 38 umfasst optional eine zweite Sensoreinheit 45 zur Erfassung einer zweiten Information an zumindest einer Position innerhalb des Lokalbereiches 23. Die erste Sensoreinheit 44 und die zweite Sensoreinheit 45 sind mit der Ermittlungseinheit verbunden und die Ermittlungseinheit dazu ausgebildet ist,
bei Ermittlung der Steuerinformation die zweite Information zu berücksichtigen. Zudem umfasst das Spulensystem eine Gradientenspuleneinheit 19 und eine Gradientensteuereinheit 28 zur Ansteuerung der Gradientenspuleneinheit 19. Die Gradientenspuleneinheit 19 umfasst typischerweise drei Gradientenleiterstrukturen 51, 52, 53 zur Erzeugung globaler Magnetfeldgradienten in drei voneinander verschiedene Raumrichtungen. Die von der Lokalspuleneinheit 31 umfasste Leiterstruktur 41 ist vorzugsweise dazu ausgebildet, einen lokalen Magnetfeldgradienten in eine erste Raumrichtung zu erzeugen, welche erste Raumrichtung parallel zu Längsachse des zylinderförmigen Lokalbereiches 23 verläuft.

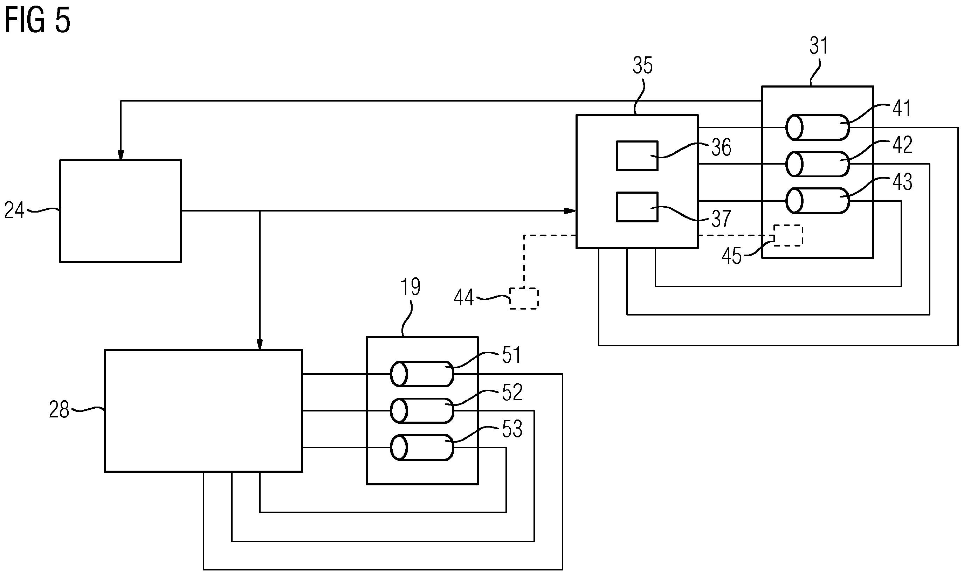

Figur 5 zeigt eine zweite Ausführungsform eines erfindungsgemäßen Spulensystems mit einer zweiten Ausführungsform eines erfindungsgemäßen Lokalspulensystems 38 in einer schematischen Darstellung. Die zweite Ausführungsform des erfindungsgemäßen Lokalspulensystems 38 unterscheidet sich von der ersten Ausführungsform des erfindungsgemäßen Lokalspulensystems 38 in der Anzahl der von der Lokalspuleneinheit 31 umfassten Leiterstrukturen 41, 42, 43 der ersten Ausführungsform und der entsprechend veränderten Verbindung der Lokalspuleneinheit 31 zur Spulensteuereinheit 35. Die Lokalspuleneinheit 31 umfasst in der dargestellten Ausführungsform drei Leiterstrukturen 41, 42, 43.

Die erste Leiterstruktur 41 ist dazu ausgebildet, einen linearen lokalen Magnetfeldgradienten in eine erste Raumrichtung zu erzeugen. Die zweite Leiterstruktur 42 ist dazu ausgebildet, einen linearen lokalen Magnetfeldgradienten in eine zweite Raumrichtung zu erzeugen.
Die dritte Leiterstruktur 43 ist dazu ausgebildet, einen linearen lokalen Magnetfeldgradienten in eine dritte Raumrichtung zu erzeugen. Vorzugsweise entsprechen die erste Raumrichtung, die zweite Raumrichtung und die dritte Raumrichtung den Raumrichtungen, in welche die von den Gradientenleiterstrukturen 51, 52, 53 erzeugbaren globalen Magnetfeldgradienten gerichtet sind.

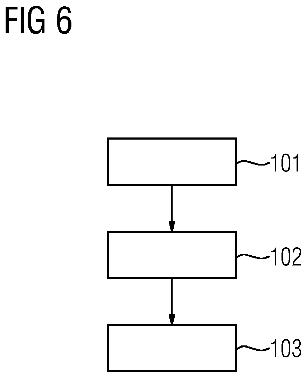

Figur 6 zeigt ein Ablaufdiagramm eines erfindungsgemäßen Verfahrens zu einer Reduzierung eines von einer Gradientenspuleneinheit erzeugten globalen Magnetfeldgradienten in einem Lokalbereich durch Erzeugung eines lokalen Magnetfeldes mittels einer erfindungsgemäßen Spuleneinheit. Gemäß Verfahrensschritt 101 erfolgt zunächst die Erfassung einer ersten Information über einen globalen Magnetfeldgradienten im Patientenaufnahmebereich. Basierend auf der ersten Information erfolgt in Verfahrensschritt 102 die Ermittlung einer Steuerinformation. In Verfahrensschritt 103 erfolgt die Ansteuerung der Leiterstruktur gemäß der Steuerinformation, wodurch ein lokales Magnetfeld im Lokalbereich in Abhängigkeit des globalen Magnetfeldgradienten erzeugt wird.

Obwohl die Erfindung im Detail durch die bevorzugten Ausführungsbeispiele näher illustriert und beschrieben wurde, so ist die Erfindung nicht durch die offenbarten Beispiele eingeschränkt und andere Variationen können vom Fachmann hieraus abgeleitet werden, ohne den Schutzumfang der Erfindung zu verlassen.

## Patentansprüche

1. Lokalspuleneinheit zur Positionierung in einem von einer Gradientenspuleneinheit umgebenen Patientenaufnahmebereich umfassend eine Leiterstruktur umgebend einen Lokalbereich wobei die Leiterstruktur dazu ausgebildet ist, im Lokalbereich ein lokales Magnetfeld zu erzeugen.

2. Lokalspuleneinheit nach Anspruch 1, wobei
die Lokalspuleneinheit dazu ausgebildet ist, das lokale Magnetfeld abhängig von einem von der Gradientenspuleneinheit im Patientenaufnahmebereich erzeugten globalen Magnetfeldgradienten zu erzeugen.

3. Lokalspuleneinheit nach einem der vorangehenden Ansprüche, wobei die Leiterstruktur derart geformt ist, dass diese auf einer Mantelfläche eines Zylinders anzuordnen ist.

4. Lokalspuleneinheit nach einem der vorangehenden Ansprüche, wobei die Leiterstruktur derart gewählt ist, dass innerhalb des von der Leiterstruktur umgebenen Lokalbereiches ein Kopf und/oder ein Brustkorb eines Untersuchungsobjektes positionierbar ist.

5. Lokalspuleneinheit nach einem der vorangehenden Ansprüche, wobei die Leiterstruktur einen zumindest teilweise spiralförmig angeordneten elektrischen Leiter umfasst.

6. Lokalspuleneinheit nach einem der vorangehenden Ansprüche, wobei die Lokalspuleneinheit zumindest zwei Leiterstrukturen umfasst,
wobei eine erste Leiterstruktur der zumindest zwei Leiterstrukturen dazu ausgebildet ist, einen linearen lokalen Magnetfeldgradienten in eine erste Raumrichtung zu erzeugen und eine zweite Leiterstruktur der zumindest zwei Leiterstrukturen dazu ausgebildet ist, einen linearen lokalen Magnetfeldgradienten in eine zweite Raumrichtung zu erzeugen.

7. Lokalspuleneinheit nach einem der vorangehenden Ansprüche, wobei die Lokalspuleneinheit eine Kühlvorrichtung umfasst.

8. Lokalspuleneinheit zur Positionierung in einem von einer Gradientenspuleneinheit umgebenen Patientenaufnahmebereich umfassend eine Leiterstruktur umgebend einen Lokalbereich wobei die Leiterstruktur dazu ausgebildet ist, im Lokalbereich einen globalen Magnetfeldgradienten abzuschirmen, wobei die Leiterstruktur als Hohlzylinder aus Metall ausgebildet ist.

9. Lokalspulensystem umfassend eine Lokalspuleneinheit nach einem der Ansprüche 1 bis 7, eine Spulensteuereinheit mit einer Ermittlungseinheit und einer Erfassungseinheit,
wobei die Erfassungseinheit dazu ausgebildet ist, eine erste Information über einen globalen Magnetfeldgradienten im Patientenaufnahmebereich zu empfangen,
die Ermittlungseinheit dazu ausgebildet ist, abhängig von der ersten Information eine Steuerinformation zu ermitteln,
die Spulensteuereinheit dazu ausgebildet ist, die Lokalspuleneinheit gemäß der Steuerinformation anzusteuern, wobei das lokale Magnetfeld erzeugt wird.

10. Lokalspulensystem nach Anspruch 9,
wobei die Ermittlungseinheit dazu ausgebildet ist, die Steuerinformation derart zu ermitteln, dass ein bei Ansteuerung der Lokalspuleneinheit gemäß der Steuerinformation erzeugtes lokales Magnetfeld den globalen Magnetfeldgradienten im Lokalbereich reduziert.

11. Lokalspulensystem nach einem der Ansprüche 9 bis 10 umfassend eine zweite Sensoreinheit zur Erfassung einer zweiten Information an zumindest einer Position innerhalb des Lokalbereiches.

12. Spulensystem umfassend eine Lokalspulensystem nach einem der Ansprüche 9 bis 11, eine Gradientenspuleneinheit und eine Gradientensteuereinheit zur Ansteuerung der zumindest einen Gradientenspuleneinheit.

13. Spulensystem nach Anspruch 12, wobei die Lokalspuleneinheit zumindest teilweise außerhalb eines Untersuchungsbereiches angeordnet ist.

14. Magnetresonanzgerät umfassend ein Spulensystem nach einem der Ansprüche 12 bis 13, einen Hauptmagneten und eine Hochfrequenzantenneneinheit, wobei das Magnetresonanzgerät zu einer Ausführung eines Verfahrens nach Anspruch 15 und zu einer Akquisition von Rohdaten ausgelegt ist.

15. Verfahren zu einer Reduzierung eines von einer Gradientenspuleneinheit erzeugten globalen Magnetfeldgradienten in einem Lokalbereich durch Erzeugung eines lokalen Magnetfeldes mittels eines Lokalspulensystems nach einem der Ansprüche 9 bis 11, gemäß den folgenden Verfahrensschritten:
- Erfassung einer ersten Information über einen globalen Magnetfeldgradienten im Patientenaufnahmebereich
- Ermittlung einer Steuerinformation abhängig von der ersten Information
- Ansteuerung der Leiterstruktur gemäß der Steuerinformation und dadurch
- Erzeugung eines lokalen Magnetfeldes im Lokalbereich in Abhängigkeit des globalen Magnetfeldgradienten.
